(19) Europäisches Patentamt
European Patent Office
Office européen des brevets

(11) EP 4 482 189 A1

(12) **EUROPEAN PATENT APPLICATION**
published in accordance with Art. 153(4) EPC

(43) Date of publication:
**25.12.2024 Bulletin 2024/52**

(21) Application number: **22927100.2**

(22) Date of filing: **17.02.2022**

(51) International Patent Classification (IPC):
***H04W 16/18*** *(2009.01)* ***H04W 16/28*** *(2009.01)*

(52) Cooperative Patent Classification (CPC):
**H04W 16/18; H04W 16/28**

(86) International application number:
**PCT/JP2022/006485**

(87) International publication number:
**WO 2023/157198 (24.08.2023 Gazette 2023/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Nippon Telegraph And Telephone Corporation**
**Chiyoda-ku**
**Tokyo 100-8116 (JP)**

(72) Inventors:
- **KINSHO, Hideaki**
  **Musashino-shi, Tokyo 180-8585 (JP)**
- **TAKESHITA, Kei**
  **Musashino-shi, Tokyo 180-8585 (JP)**

(74) Representative: **Murgitroyd & Company**
**165-169 Scotland Street**
**Glasgow G5 8PL (GB)**

(54) **TILT ANGLE OPTIMIZING DEVICE, TILT ANGLE OPTIMIZING METHOD, AND PROGRAM**

(57) An object of the present disclosure is to achieve better area quality by optimizing a tilt angle of each antenna at each base station forming a cellular network.

For that reason, the present disclosure provides a tilt angle optimization apparatus configured to perform optimization of a tilt angle of each of antennas forming a cellular network, including a performance model construction unit configured to construct a performance model by modeling a relationship between the number of active users in each of the antennas and performance providable by each of the antennas, a user distribution estimation unit configured to estimate a user distribution of active users around each of base stations based on statistical data observed at each of the base stations, and a tilt angle optimization unit configured to obtain the tilt angle of each of the antennas based on the constructed performance model and the estimated user distribution in order to maximize area quality in a specified target area.

Fig. 1

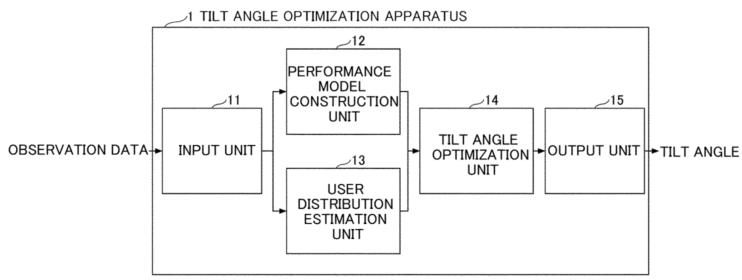




Processed by Luminess, 75001 PARIS (FR)

## Description

### Technical Field

The present disclosure relates to an invention for performing optimization of a tilt angle of a base station forming a cellular network.

### Background Art

A cellular network is generally configured of many base stations as elements, each base station covers its surrounding area, and thus a user can perform communication via surrounding base stations. A range covered by each base station is determined depending on setting values of various parameters, and one representative parameter is a tilt angle of an antenna of a base station. A tilt angle of each antenna is often changed to improve coverage holes, overlapping, and area quality (NPL 1). In addition, recently, a method in which optimization is performed in cooperation with surrounding base stations has been proposed (NPL 2).

### Citation List

### Non-Patent Literature

NPL 1: Ferhad Kasem, Abdullah Haskou, and Zaher Dawy: On Antenna Parameters Self Optimization in LTE Cellular Networks, 2013 Third International Conference on Communications and Information Technology (ICCIT), p. 44-48.
NPL 2: Hasan Farooq, Ahmad Asghar: Mobility Prediction Based Proactive Dynamic Network Orchestration for Load Balancing With QoS Restriction (OPERA), IEEE TRANSACTIONS ON VEHICULAR TECHNOLOGY, VOL. 69, No. 3, MARCH 2020, p. 3370-3383.

### Summary of Invention

### Technical Problem

However, in the invention disclosed in NPL 1, since optimization is performed for each base station and not in cooperation with surrounding base stations, there is a concern that coverage holes and excessive overlapping may occur, and area quality cannot be sufficiently improved.
In addition, the invention disclosed in NPL 2 is a method for performing optimization in cooperation with surrounding base stations, but tilt angles are frequently optimized in accordance with movement of a user by utilizing speed information of the user's terminal such as a mobile phone, and thus it is difficult to apply this method to an actual network in which the tilt angles cannot be changed frequently during operation.
The present invention has been made in view of the above points, and an object thereof is to achieve better area quality.

### Solution to Problem

In order to achieve the above object, the invention according to claim 1 is a tilt angle optimization apparatus configured to perform optimization of a tilt angle of each of antennas in each of base stations forming a cellular network, including a performance model construction unit configured to construct a performance model by modeling a relationship between the number of active users in each of the antennas and performance providable by each of the antennas, a user distribution estimation unit configured to estimate a user distribution of active users around each of the base stations based on statistical data observed at each of the base stations, and a tilt angle optimization unit configured to obtain the tilt angle of each of the antennas based on the constructed performance model and the estimated user distribution in order to maximize area quality in a specified target area.

### Advantageous Effects of Invention

As described above, according to the present invention, by optimizing the tilt angle of each antenna in cooperation with each antenna, it is possible to achieve better area quality.

Brief Description of Drawings

[Fig. 1] Fig. 1 is a functional configuration diagram of a tilt angle optimization apparatus according to an embodiment.
[Fig. 2] Fig. 2 is a hardware configuration diagram of the tilt angle optimization apparatus according to the embodiment.
[Fig. 3] Fig. 3 is a flowchart showing tilt angle optimization processing according to the embodiment.
[Fig. 4] Fig. 4 is a conceptual diagram showing attribute information.
[Fig. 5] Fig. 5 is a conceptual diagram showing observation information.
[Fig. 6] Fig. 6 is a flowchart showing detailed processing for constructing a performance model.
[Fig. 7] Fig. 7 is a flowchart showing detailed processing of tilt angle optimization.
[Fig. 8] Fig. 8 is a diagram showing meanings of each parameter.
[Fig. 9] Fig. 9 is a diagram showing meanings of each parameter.

Description of Embodiments

[Functional Configuration of Tilt Angle Optimization Apparatus]

An embodiment of the present invention will be described below. A tilt angle optimization apparatus 1 of the present embodiment constructs a performance model of an antenna of a base station and estimates a user distribution around the base station using statistics already observed in an actual network and optimizes a tilt angle of the antenna based on the performance model and the user distribution in cooperation with antennas of a plurality of base stations to achieve better area quality. Hereinafter, as an example, it is assumed that observation information of an antenna $c_i$ (i = 1, 2, ... , and $N_c$)

[Math. 1]

$$d_{c_i}^{(t)}$$

represents the number of accommodated users and throughput of the antenna $c_i$. Here, the observation information is acquired every hour. The number of accommodated users represents an average value per hour (60 units) when users accommodated by the antenna $c_i$ are counted in units of one minute. The throughput represents a value obtained by further averaging average throughputs of users calculated in units of one minute over one hour.

Also, in the present embodiment, a case in which there are a plurality of antennas in one base station is assumed. Further, a tilt angle of an antenna includes a fixed mechanical tilt and a changeable electric tilt, but in the present embodiment, a tilt angle to be changed of a remotely-changeable-electric-tilt antenna is determined.

First, a functional configuration of the tilt angle optimization apparatus 1 according to the present embodiment will be described with reference to Fig. 1. Fig. 1 is a functional configuration diagram of the tilt angle optimization apparatus according to the present embodiment. As shown in Fig. 1, the tilt angle optimization apparatus 1 according to the present embodiment includes an input unit 11, a performance model construction unit 12, a user distribution estimation unit 13, a tilt angle optimization unit 14, and an output unit 15. Each of these units corresponds to a function realized by instructions from a processor 101 in Fig. 2, which will be described later, on the basis of a program.

The input unit 11 inputs attribute information and observation information of $c_i$ (i = 1, 2,..., and $N_c$).

The performance model construction unit 12 performs, in order to improve area quality of a target area, for a base station group with antennas whose tilt angles can be changed, modeling on a relationship between the number of active users simultaneously connected to the antennas and performance providable to the users connected to the antennas at that time using statistical data observed at the base station group (for example, in a range of a circle with a radius of 500 m or a 1 km square).

The "target area" is the region in which area quality is desired to be improved and may be part or all of a geographical space divided into mesh units of arbitrary sizes, or may be arbitrarily designated by an operator of a communication carrier.

The "area quality" is the quality that can be provided to all users existing in the target area and may be an average value of the maximum throughputs, an average value of the maximum channel quality indicators (CQI), or an average value of the maximum connection completion rates.

The "number of active users" is the number of users who actually perform communication via the antennas of the base stations.

The "performance providable to users connected to antennas" is an average throughput, an average CQI, an average connection completion rate, or the like.

In general, since resources of the base stations are finite, the performance providable to the users connected to the antennas varies depending on the number of active users simultaneously connected thereto. The construction of the performance model may be constructed by supervised learning using a plurality of pieces of statistical data about the number of active users and the performance observed at the base stations, or may be constructed by assuming an appropriate function through data analysis and performing fitting thereto.

Similarly to the performance model construction unit 12, the user distribution estimation unit 13 estimates the user distribution around the base station group using statistical data observed at the base station group. The user distribution to be estimated is a distribution of the number of active users and can be estimated using a technique described in Reference 1, for example. By using this technique, the number of active users in mesh units can be estimated by applying an extended block kriging method to the number of active users for each antenna observed at each base station.

<Reference 1> The Institute of Electronics, Information and Communication Engineers, IEICE Technical Report CQ2021-49 (2021-09) "Extension of Block Kriging for User Distribution Estimation in Cellular Networks"

The tilt angle optimization unit 14 optimizes the tilt angle of each antenna included in the base station group based on the performance model and the user distribution for the purpose of maximizing the area quality. When the optimization is performed, it is treated as a black box optimization problem, and a solution is obtained without explicitly showing a relationship between a set value of the tilt angle of each antenna and the area quality. The black box optimization problem is a problem of obtaining the maximum value or minimum value of a function which is difficult to express explicitly because of a complicated relationship between input and output, and by using a combination of tilt angles of respective antennas as input and the area quality at that time as output, the present study can be regarded as the black box optimization problem. This black box optimization problem may be solved using, for example, a metaheuristic method such as particle swarm optimization or a genetic algorithm, or Bayesian optimization or reinforcement learning. Also, as a restriction condition, a restriction regarding coverage of the target area or a restriction regarding minimum quality may be added. The restriction regarding the coverage is, for example, in a case in which the target area is divided into meshes, a restriction for setting the maximum value of reference signal received power (RSRP) in each mesh to be equal to or greater than a threshold. The restriction regarding the minimum quality is, for example, a restriction for setting the number of active users simultaneously connected to each antenna to be equal to or less than a threshold. In the case of adding a restriction condition, not only the area quality but also a penalty term representing a penalty for not satisfying the restriction condition is added as output. For example, in the case of maximizing the output, an evaluation value whose output value decreases in accordance with the number of meshes in which the RSRP is less than a threshold may be used, or an evaluation value whose output value becomes zero if the restriction condition is not satisfied may be used.

The output unit 15 outputs the tilt angle finally obtained by the tilt angle optimization unit 14. Also, the output unit 15 may output the tilt angle to an arbitrary output destination. For example, the output unit 15 may output the tilt angle to a server device or the like via a communication network such as the Internet, may output the tilt angle to a display or the like, or may output the tilt angle to an auxiliary storage device or the like.

[Hardware Configuration of Tilt Angle Optimization Apparatus]

Next, a hardware configuration of the tilt angle optimization apparatus 1 will be described using Fig. 2. Fig. 2 is a hardware configuration diagram of the tilt angle optimization apparatus according to the embodiment.

As shown in Fig. 2, the tilt angle optimization apparatus 1 includes a processor 101, a memory 102, an auxiliary storage device 103, a connection device 104, a communication device 105, and a drive device 106. Also, each piece of hardware constituting the tilt angle optimization apparatus 1 is interconnected to each other via a bus 107.

The processor 101 serves as a control unit that performs control of the entire tilt angle optimization apparatus 1 and has various arithmetic devices such as a central processing unit (CPU). The processor 101 reads out various programs onto the memory 102 and executes them. Also, the processor 101 may include general-purpose computing on graphics processing units (GPGPUs).

The memory 102 has main storage devices such as a read only memory (ROM) and a random access memory (RAM). The processor 101 and the memory 102 form a so-called computer, and the processor 101 executes various programs read on the memory 102, thereby causing the computer to realize various functions.

The auxiliary storage device 103 stores various programs and various kinds of information used when the various programs are executed by the processor 101.

The connection device 104 is a connection device that connects external devices (for example, a display device 110 and an operation device 111) and the tilt angle optimization apparatus 1.

The communication device 105 is a communication device for transmitting and receiving various kinds of information to and from other devices.

The drive device 106 is a device for setting a (non-transitory) recording medium 130. The recording medium 130 mentioned herein includes a medium that optically, electrically, or magnetically records information, such as a compact disc read-only memory (CD-ROM), a flexible disk, or a magneto-optical disk. Also, the recording medium 130 may include a semiconductor memory that electrically records information, such as a read only memory (ROM) or a flash memory.

Also, for example, the distributed recording medium 130 is set in the drive device 106 and various programs recorded on the recording medium 130 are read by the drive device 106, whereby the various programs to be installed in the auxiliary storage device 103 are installed. Alternatively, the various programs installed in the auxiliary storage device 103 may be installed by being downloaded from a network via the communication device 105.

[Tilt Angle Optimization Processing]

Next, tilt angle optimization processing of the present embodiment will be described using Fig. 3. Fig. 3 is a flowchart showing tilt angle optimization processing according to the embodiment.

First, the input unit 11 inputs attribute information A and observation information D of the antenna $c_i$ (i = 1, 2,..., and $N_c$) (S11). Also, Fig. 4 is a conceptual diagram showing attribute information. Also, the "antenna ID" in Fig. 4 is an example of antenna identification information for identifying an antenna. The "position" indicates a position on the Earth (latitude and longitude). Fig. 5 is a conceptual diagram showing observation information.

Next, the performance model construction unit 12 constructs a performance model on the basis of the observation information D input by the input unit 11 (S12). As an example, processing of the performance model construction unit will be described with reference to Fig. 4. Fig. 4 is a flowchart showing an example of processing in the performance model construction unit according to the present embodiment.

Here, the processing (S12) will be described in detail using Fig. 6. Also, meanings of each parameter are shown in Fig. 8.

First, the performance model construction unit 12 performs, with respect to the number of active users held in the observation information D,

[Math. 2]

$$N_{c_i}^{(t)}$$

binning of the observation information D into $N_b$ pieces, and

[Math. 3]

$$D_{b_k}\ (k=1,2,\cdots,N_b)$$

is obtained. Also,

[Math. 4]

$$D=\bigcup_{k=1}^{N_b} D_{b_k}$$

is obtained. For example, in the case of classifying the number of active users from 1 to 100 into 10 bins, a width of one bin is 10, observation information D with the number of active users of 5 is stored in a first bin, and observation information D with the number of active users of 13 is stored in a second bin (S121). That is, if the number of active users of arbitrary observation information is 5, this observation information belongs to bin 1 (the number of active users of 1 to 10), and if the number of active users of another observation information is 13, this another observation information belongs to bin 2 (the number of active users of 11 to 20).

Next, by the performance model construction unit 12, for each of the bins classified in the processing (S121), the maximum value of the performance values held by the observation information D included in each of the bins

[Math. 5]

$$\max_{p_{c_i}^{(t)} \in D_{b_k}} \left(p_{c_i}^{(t)}\right),\ \left(k=1,2,\cdots,N_b\right)$$

is extracted (S122).

Specifically, in a case in which observation information D1 and observation information D2 are included in the bin 1, and a performance value held by the observation information D1 is 1,000 and a performance value held by the observation information D2 is 2,000, the performance model construction unit 12 extracts 2,000 as the maximum value of the performance values in the bin 1.

Next, the performance model construction unit 12 regards a representative value of the number of active users in each of the bins classified in the processing (S121) and the maximum value of the performance in each of the bins extracted in the processing (S122) as one data

[Math. 6]

$$(N_{b_k}, p_{b_k}),\ (k=1,2,\cdots,N_b)$$

and constructs the performance model by applying Gaussian process regression to the data (S123). Here, the representative value of the number of active users may be an average value of the number of active users of the observation information included in each of the bins or may be the middle of a bin interval. The "middle of a bin interval" means that, for example, in the case of the bin 1 where the interval is 1 to 10, the middle is 5.5. In the Gaussian process regression, the performance model construction unit 12 constructs a model by performing learning using input as the representative value of the number of active users and output as the performance extracted in the processing (S122).

As described above, in the processing (S12), the performance model construction unit 12 constructs the performance model on the basis of the observation information input in the processing (S11).

Next, in Fig. 3, the user distribution estimation unit 13 estimates the user distribution on the basis of the attribute information and the observation information input by the input unit 11 (S13). For example, the user distribution estimation unit 13 can estimate the number of active users in mesh units using the technique described in Reference 1.

Next, the tilt angle optimization unit 14 optimizes the tilt angle (S14) based on the performance model constructed in the processing (S12) and the user distribution estimated in the processing (S13) for the purpose of maximizing the area quality. As an example of this processing (S14), processing of the tilt angle optimization unit will be described in detail with reference to Fig. 7. Fig. 7 is a flowchart showing an example of the processing of the tilt angle optimization unit according to the present embodiment. Also, meanings of each parameter are shown in Fig. 9.

First, in the tilt angle optimization unit 14, the estimated value of the tilt angle

[Math. 7]

$$\hat{x}$$

is initialized (S141).

Next, in the tilt angle optimization unit 14, the area quality when the estimated value of the tilt angle

[Math. 8]

$$\hat{x}$$

is set as input (data)

[Math. 9]

$$\hat{q} = \sum_{c_i \in C} \left\{ \frac{\Sigma_{m_l \in M} \hat{N}_{u,c_i,m_l}}{\Sigma_{m_l \in M} N_{u,m_l}} \cdot f_i(\hat{N}_{u,c_i}) \right\}$$

is calculated (S142). However, since the relationship between the tilt angle and the area quality is not explicit, the tilt angle optimization unit 14 obtains the area quality by simulation.

Next, in the tilt angle optimization unit 14, using a technique of Bayesian optimization, a solution candidate for the tilt angle

[Math. 10]

$$x^*$$

is selected (S143). Then, in the tilt angle optimization unit 14, as described above, the area quality when the solution candidate for the tilt angle

[Math. 11]

$$x^*$$

is set as input

[Math. 12]

$$q^*$$

is calculated by simulation (S144). Then, in the case of

[Math. 13]

$$q^* > \hat{q}$$

(S145; YES), the tilt angle optimization unit 14 updates the area quality

[Math. 14]

$$\hat{q}$$

to

[Math. 15]

$$q^*$$

and updates the estimated value of the tilt angle

[Math. 16]

$$\hat{x}$$

to

[Math. 17]

$$x^*$$

(S146). On the other hand, in the case of

[Math. 18]

$$q^* \leq \hat{q}$$

(S145; no), the tilt angle optimization unit 14 does not update the estimated value and the area quality.

Next, if a termination condition is satisfied (S147; YES), the processing of Fig. 7 is terminated, and if the termination condition is not satisfied (S147; no), the process returns to the processing (S143). The termination condition in this case includes a case in which the number of repetitions of returning to the processing (S143) reaches an upper limit, a case in which the area quality

[Math. 19]

$$\hat{q}$$

becomes equal to or higher than a target value, or a case in which it converges to a constant value.

As described above, in the processing (S14), the tilt angle optimization unit 14 optimizes the tilt angle.

Next, in Fig. 3, the output unit 15 outputs the estimated value of the tilt angle obtained in the above-mentioned processing (S14).

[Main Effects of Embodiment]

As described above, according to the present embodiment, the tilt angle optimization apparatus 1 achieves the following effect in which, by constructing the performance model of the antenna of the base station and estimating the user distribution around the antenna of the base station using the statistics already observed in the actual network, the tilt angle optimization apparatus 1 can optimize the tilt angle based on the performance model and the user distribution in cooperation with the antennas of the plurality of base stations in order to achieve better area quality.

Also, tilt angles of not only a single antenna but also a plurality of antennas can be optimized simultaneously while satisfying the restriction condition. That is, in the present embodiment, in the case of determining the tilt angle, the optimization can be achieved by determining each tilt angle in cooperation with the plurality of antennas, rather than determining the tilt angle independently for each antenna.

[Supplementary Notes]

The present invention is not limited to the above-described embodiment and may be configured or processed (operated) as described below.

Although each functional configuration of the tilt angle optimization apparatus 1 can be realized by a computer and a program as described above, this program can be recorded on a (non-transitory) recording medium and provided, or it can be provided through a network such as the Internet.

Reference Signs List

1 Tilt angle optimization apparatus
11 Input unit
12 Performance model construction unit
13 User distribution estimation unit
14 Tilt angle optimization unit
15 Output unit

## Claims

1. A tilt angle optimization apparatus configured to perform optimization of a tilt angle of each of antennas at each of base stations forming a cellular network, the tilt angle optimization apparatus comprising:

   a performance model construction unit configured to construct a performance model by modeling a relationship between a number of active users of each of the antennas and performance providable by each of the antennas;
   a user distribution estimation unit configured to estimate a user distribution of active users around each of the base stations based on statistical data observed at each of the base stations; and
   a tilt angle optimization unit configured to obtain the tilt angle of each of the antennas based on the constructed performance model and the estimated user distribution in order to maximize area quality in a specified target area.

2. The tilt angle optimization apparatus according to claim 1, wherein the performance model construction unit constructs the performance model by using a plurality of pieces of data including sets of the number of active users and the performance actually observed at each of the antennas, classifying the number of active users into arbitrary bins, and using a maximum value within each of the bins as a representative point.

3. The tilt angle optimization apparatus according to claim 1, wherein the performance model construction unit constructs the performance model by applying Gaussian process regression.

4. The tilt angle optimization apparatus according to claim 1, wherein the tilt angle optimization unit outputs the tilt angle of each of the antennas in order to maximize the area quality in the target area under a restriction condition.

5. The tilt angle optimization apparatus according to claim 4, wherein the restriction condition is a restriction regarding coverage of the target area or a restriction regarding minimum area quality.

6. A tilt angle optimization method executed by a tilt angle optimization apparatus configured to perform optimization of a tilt angle of each of antennas at each of base stations forming a cellular network, the tilt angle optimization method comprising:

   constructing a performance model by modeling a relationship between a number of active users in each of the antennas and performance providable by each of the antennas;
   estimating a user distribution of active users around each of the base stations based on statistical data observed at each of the base stations; and
   obtaining the tilt angle of each of the antennas based on the constructed performance model and the estimated user distribution in order to maximize area quality in a specified target area.

7. A program for causing a computer to execute the method of claim 6.

Fig. 1

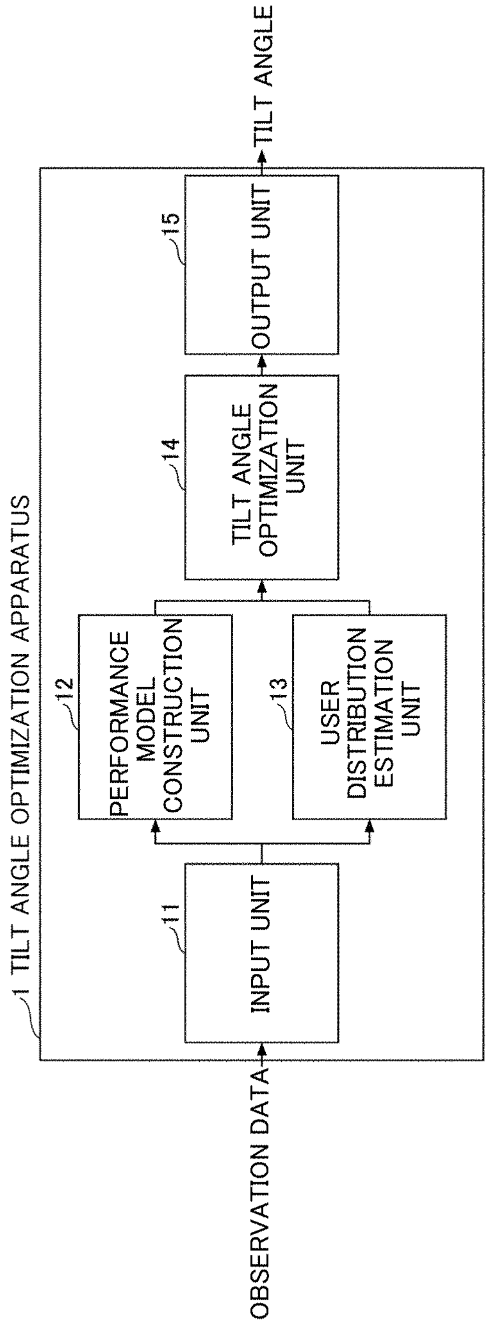
1 TILT ANGLE OPTIMIZATION APPARATUS
OBSERVATION DATA
11
INPUT UNIT
12
PERFORMANCE MODEL CONSTRUCTION UNIT
13
USER DISTRIBUTION ESTIMATION UNIT
14
TILT ANGLE OPTIMIZATION UNIT
15
OUTPUT UNIT
TILT ANGLE

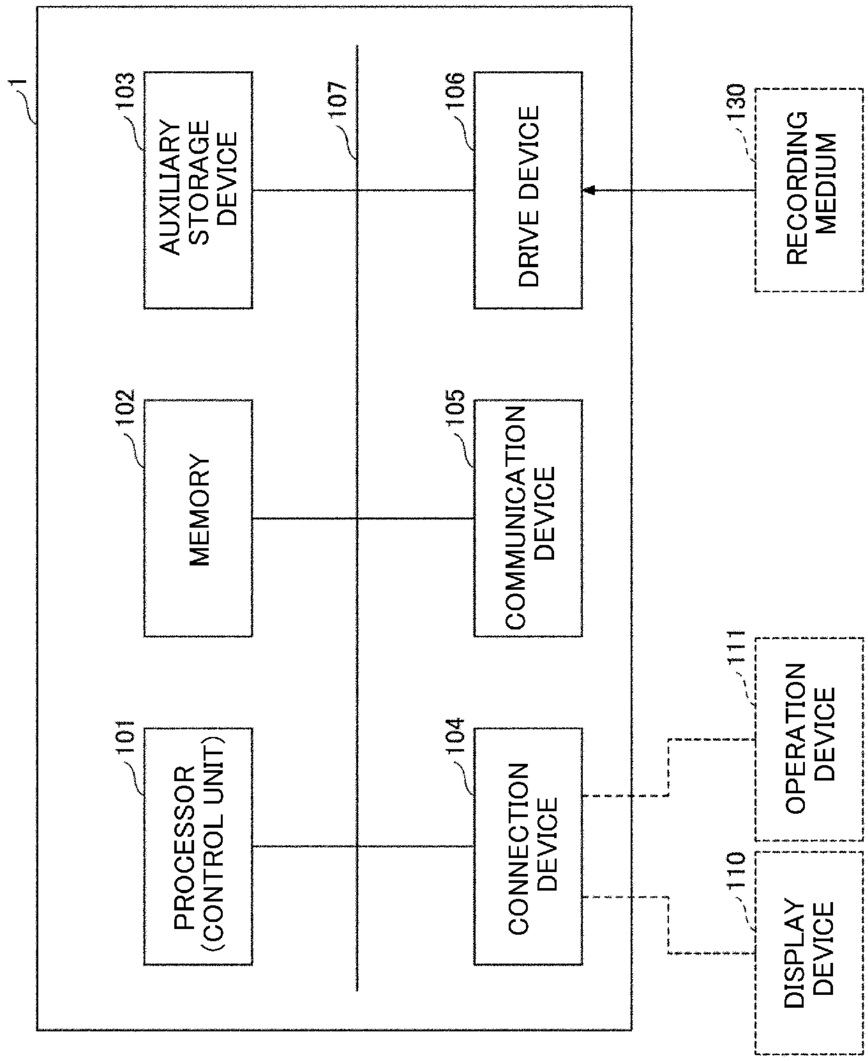
1
101
PROCESSOR (CONTROL UNIT)
102
MEMORY
103
AUXILIARY STORAGE DEVICE
104
CONNECTION DEVICE
105
COMMUNICATION DEVICE
106
DRIVE DEVICE
107
110
DISPLAY DEVICE
111
OPERATION DEVICE
130
RECORDING MEDIUM

Fig. 2

Fig. 3

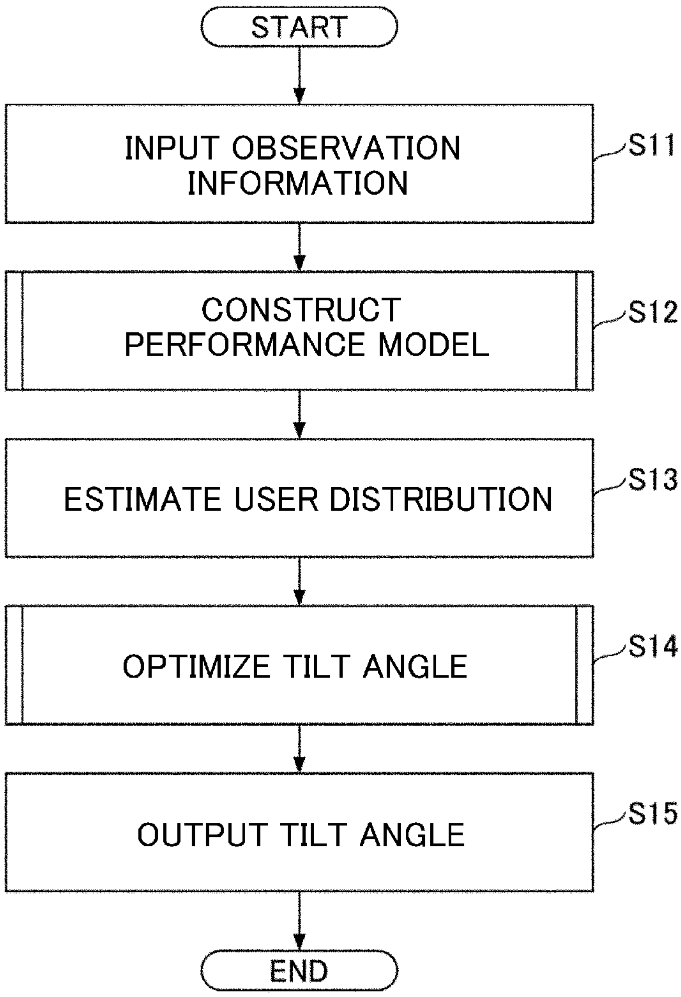
START
INPUT OBSERVATION INFORMATION
S11
CONSTRUCT PERFORMANCE MODEL
S12
ESTIMATE USER DISTRIBUTION
S13
OPTIMIZE TILT ANGLE
S14
OUTPUT TILT ANGLE
S15
END

Fig. 4

| ANTENNA ID | ATTRIBUTE INFORMATION A | | | | | | |
|---|---|---|---|---|---|---|---|
| | POSITION | FREQUENCY BAND | BANDWIDTH | AZIMUTH ANGLE | BEAM WIDTH | TILT ANGLE | ANTENNA HEIGHT |
| $C_1$ | (139,40) | 2GHz | 20MHz | 90° | 120° | 5° | 20m |
| ⋮ | ⋮ | ⋮ | ⋮ | ⋮ | ⋮ | ⋮ | ⋮ |

Fig. 5

| ANTENNA ID | OBSERVATION INFORMATION D | | |
|---|---|---|---|
| | 2022/1/1 9:00 | 2022/1/1 10:00 | 2022/1/1 11:00 |
| $C_1$ | (10 PERSONS, 8000 kbps) | (20 PERSONS, 4000 kbps) | (10 PERSONS, 7800 kbps) |
| ⋮ | ⋮ | ⋮ | ⋮ |

Fig. 6

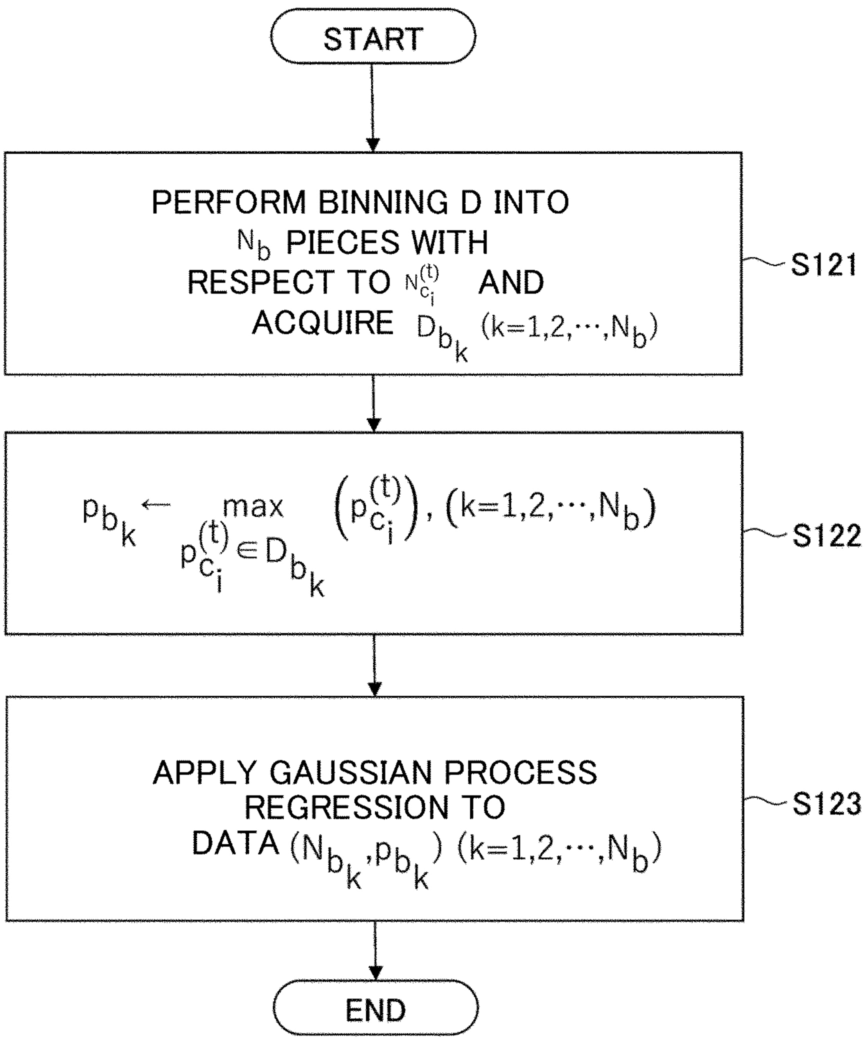
START
PERFORM BINNING D INTO $N_b$ PIECES WITH RESPECT TO $N_{c_i}^{(t)}$ AND ACQUIRE $D_{b_k}$ $(k=1,2,\cdots,N_b)$
S121
$p_{b_k} \leftarrow \max_{p_{c_i}^{(t)} \in D_{b_k}} \left(p_{c_i}^{(t)}\right), (k=1,2,\cdots,N_b)$
S122
APPLY GAUSSIAN PROCESS REGRESSION TO DATA $(N_{b_k}, p_{b_k})$ $(k=1,2,\cdots,N_b)$
S123
END

Fig. 7

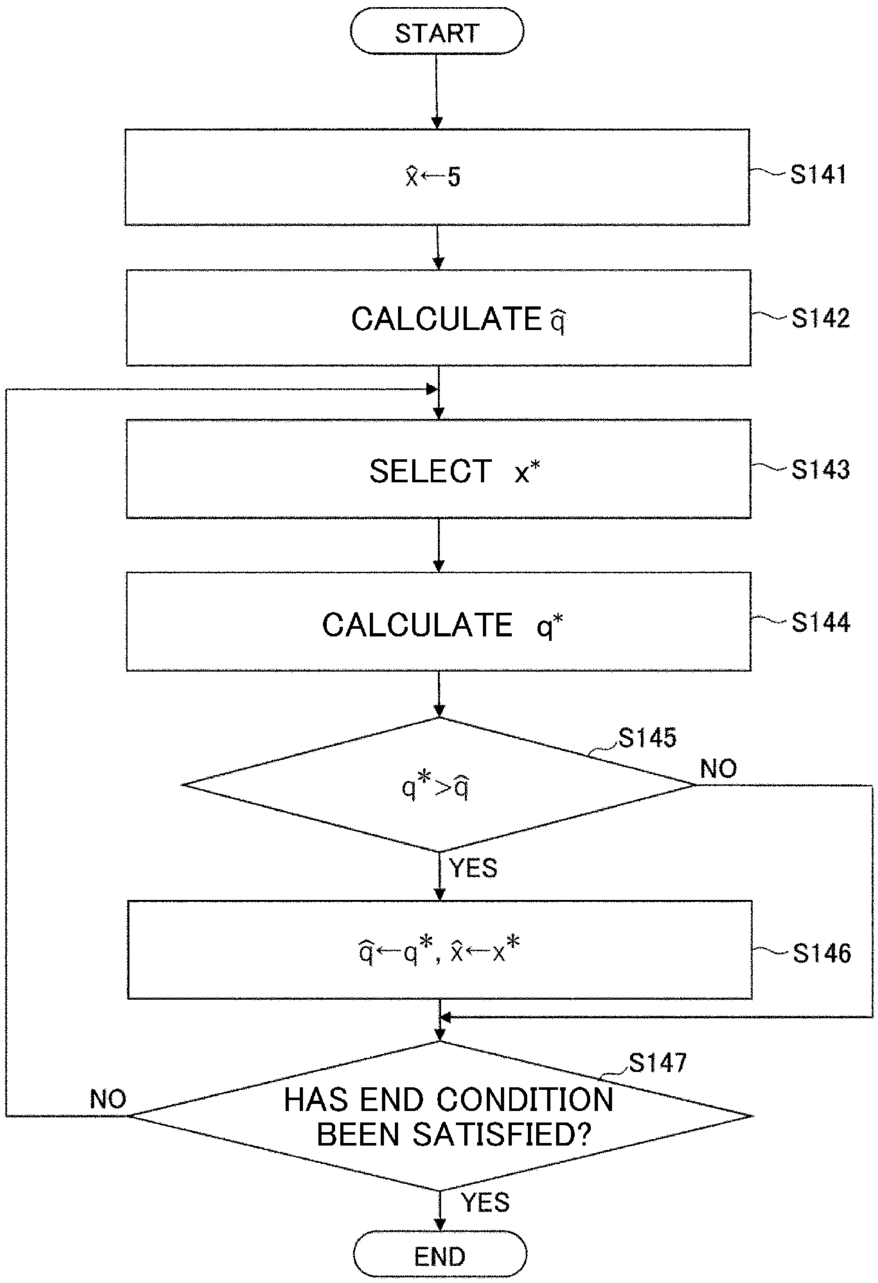
START
x̂←5
S141
CALCULATE q̂
S142
SELECT x*
S143
CALCULATE q*
S144
q*>q̂
S145
NO
YES
q̂←q*, x̂←x*
S146
HAS END CONDITION BEEN SATISFIED?
S147
NO
YES
END

Fig. 8

$D_{b_k}$ : SET OF OBSERVATION INFORMATION $d_{c_i}^{(t)}$ CLASSIFIED INTO K-TH BIN

$N_{b_k}$: REPRESENTATIVE VALUE OF $N_{c_i}^{(t)}$ IN BIN $b_k$

Fig. 9

$\hat{N}_{u,c_i,m_l}$ : ESTIMATED VALUE OF NUMBER OF USERS BELONGING TO MESH $m_l$ AND CONNECTED TO ANTENNA $c_i$

$N_{u,m_l}$ : NUMBER OF USERS BELONGING TO MESH $m_l$ ESTIMATED BY USER DISTRIBUTION ESTIMATION UNIT

$\hat{N}_{u,c_i}$ : ESTIMATED VALUE OF NUMBER OF USERS CONNECTED TO ANTENNA $c_i$

$f_i(\hat{N}_{u,c_i})$: MODEL OBTATINED BY PERFORMANCE MODEL CONSTRUCTION UNIT

$\hat{x}$, $x^*$ : TILT ANGLE VECTOR

$\hat{q}$, $q^*$ : AREA QUALITY

**INTERNATIONAL SEARCH REPORT**

International application No. **PCT/JP2022/006485**

**A. CLASSIFICATION OF SUBJECT MATTER**

***H04W 16/18***(2009.01)i; ***H04W 16/28***(2009.01)i
FI: H04W16/18; H04W16/28

According to International Patent Classification (IPC) or to both national classification and IPC

**B. FIELDS SEARCHED**

Minimum documentation searched (classification system followed by classification symbols)

H04B7/24-7/26; H04W4/00-99/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2012-54736 A (HITACHI, LTD.) 15 March 2012 (2012-03-15) paragraphs [0006]-[0007], [0011]-[0029] | 1, 4-7 |
| Y | paragraphs [0006]-[0007], [0011]-[0029] | 3 |
| A | paragraphs [0006]-[0007], [0011]-[0029] | 2 |
| Y | JP 2018-508149 A (QUALCOMM, INC.) 22 March 2018 (2018-03-22) paragraph [0108] | 3 |
| A | WO 2014/136739 A1 (NEC CORP.) 12 September 2014 (2014-09-12) entire text | 1-7 |
| A | JP 2012-175467 A (MITSUBISHI ELECTRIC CORP.) 10 September 2012 (2012-09-10) entire text | 1-7 |
| A | WO 2011/151857 A1 (FUJITSU LTD.) 08 December 2011 (2011-12-08) entire text | 1-7 |
| A | JP 2009-290494 A (KYOCERA CORP.) 10 December 2009 (2009-12-10) entire text | 1-7 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 May 2022** | **24 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/006485**

| Patent document cited in search report | Publication date (day/month/year) | Patent family member(s) | Publication date (day/month/year) |
| --- | --- | --- | --- |
| JP 2012-54736 A | 15 March 2012 | (Family: none) | |
| JP 2018-508149 A | 22 March 2018 | US 2016/0255603 A1<br>paragraph [0128] | |
| WO 2014/136739 A1 | 12 September 2014 | (Family: none) | |
| JP 2012-175467 A | 10 September 2012 | (Family: none) | |
| WO 2011/151857 A1 | 08 December 2011 | US 2013/0090128 A1<br>entire text | |
| JP 2009-290494 A | 10 December 2009 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **FERHAD KASEM** ; **ABDULLAH HASKOU** ; **ZAHER DAWY**. On Antenna Parameters Self Optimization in LTE Cellular Networks. *2013 Third International Conference on Communications and Information Technology (ICCIT)*, 44-48
- **HASAN FAROOQ** ; **AHMAD ASGHAR**. Mobility Prediction Based Proactive Dynamic Network Orchestration for Load Balancing With QoS Restriction (OPERA). *IEEE TRANSACTIONS ON VEHICULAR TECHNOLOGY*, March 2020, vol. 69 (3), 3370-3383